(19) Europäisches Patentamt
European Patent Office
Office européen des brevets

(11) **EP 3 204 825 B1**

(12) **EUROPÄISCHE PATENTSCHRIFT**

(45) Veröffentlichungstag und Bekanntmachung des Hinweises auf die Patenterteilung:
**27.02.2019 Patentblatt 2019/09**

(21) Anmeldenummer: **15767470.6**

(22) Anmeldetag: **22.09.2015**

(51) Int Cl.:
**G03F 7/20** (2006.01)     **G03F 9/00** (2006.01)

(86) Internationale Anmeldenummer:
**PCT/EP2015/071709**

(87) Internationale Veröffentlichungsnummer:
**WO 2016/055259 (14.04.2016 Gazette 2016/15)**

(54) **OPTISCHES SYSTEM ZUR LITHOGRAFISCHEN STRUKTURERZEUGUNG**

OPTICAL SYSTEM FOR PRODUCING LITHOGRAPHIC STRUCTURES

SYSTÈME OPTIQUE POUR LA PRODUCTION D'UNE STRUCTURE PAR LITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.10.2014 DE 102014220168**

(43) Veröffentlichungstag der Anmeldung:
**16.08.2017 Patentblatt 2017/33**

(73) Patentinhaber: **Carl Zeiss AG**
**73447 Oberkochen (DE)**

(72) Erfinder:
• **HÜBNER, Philipp**
**22083 Hamburg (DE)**
• **KRAMPERT, Gerhard**
**94566 Pleasanton, CA (US)**
• **RICHTER, Stefan**
**07743 Jena (DE)**
• **MAPPES, Timo**
**76135 Karlsruhe (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**US-A1- 2008 112 609     US-A1- 2013 221 550**

**Beschreibung**

Die vorliegende Patentanmeldung nimmt die Priorität der deutschen Patentanmeldung DE 10 2014 220 168.3 in Anspruch.

Die Erfindung betrifft ein optisches System zur lithografischen Strukturerzeugung. Ferner betrifft die Erfindung ein Verfahren zur Bestimmung von Relativkoordinaten einer Lage eines Schreibfeldes relativ zu einer Lage eines Vorschaufeldes in einem derartigen optischen System und ein Verfahren zur lithografischen Strukturerzeugung mit einem derartigen optischen System.

Ein optisches System der eingangs genannten Art ist bekannt aus der US 2013/0221550 A1, wobei eine Projektionsoptik mit Objektivlinse zur Führung eines strukturerzeugenden Schreiblichtbündels auf ein Substrat offenbart wird, das von einem Substrathalter getragen ist. Als Ablenkeinrichtung zur Ablenkung eines Schreibfokus des Schreiblichtbündels dient ein Scanspiegel. Ein optisches System der eingangs genannten Art ist außerdem bekannt aus der US 2013/0 223 788 A1. Aus der DE 103 15 086 A1 sind ein Verfahren und eine Vorrichtung zum Ausrichten von Halbleiterwafern bei der Halbleiterherstellung bekannt. Die dort offenbarte Lithographieanlage umfasst eine Belichtungseinheit, eine erste optische Messeinrichtung, aufweisend ein Ausrichtungsmikroskop, und eine weitere Streustrahlungsmesseinrichtung. Ein Waferhalter ist bei dieser Lithographieanlage auf einer Positionierungseinrichtung angeordnet. Die US 2008/0 112 609 A1 beschreibt ein Positionierverfahren sowie eine Positioniervorrichtung unter Nutzung eines Ausrichtmarken aufweisenden Substrats.

Es ist eine Aufgabe der vorliegenden Erfindung, ein derartiges optisches System derart weiterzubilden, dass eine Positionierung eines Substrats, welches bei der lithografischen Strukturerzeugung bearbeitet wird, insbesondere mit guter Zielgenauigkeit erreicht werden kann. Insbesondere soll ermöglicht werden, eine möglichst exakte Position für eine zu erzeugende Struktur auf einer relativ zur Strukturgröße sehr großen Substratfläche aufzufinden, da das Schreibfeld regelmäßig nur einen sehr kleinen Ausschnitt einer gesamten Substratfläche bietet, auf der positionsgenau eine gewünschte Struktur erzeugt werden soll.

Diese Aufgabe ist erfindungsgemäß gelöst durch ein optisches System mit den im Anspruch 1 angegebenen Merkmalen.

Erfindungsgemäß wurde erkannt, dass eine Positionierung des zu strukturierenden Substrats so, dass die zu erzeugende Struktur in einer Schreib-Zielposition erzeugt wird, unter Zuhilfenahme abgelegter Relativkoordinaten, die die Lage des Schreibfeldes relativ zur Lage eines Vorschaufeldes spezifizieren, verbessert ist. Hierbei wird dem Umstand Rechnung getragen, dass das Schreibfeld regelmäßig sehr klein ist, wobei ein im Verhältnis hierzu viel größeres Vorschaufeld zum Einsatz kommt. Das Vorschaufeld wiederum deckt regelmäßig nur einen kleinen Teil einer gesamten Substrat-Oberfläche ab, auf der die Struktur positionsgenau erzeugt werden soll. Das Schreibfeld kann dann für den strukturerzeugenden Prozess optimiert werden und kann insbesondere sehr klein ausgeführt werden. Eine typische Größe des Vorschaufeldes ist 10 x 10 mm². Eine typische Größe des Schreibfeldes ist 400 x 400 $\mu$m². Das Vorschaufeld kann um einen Faktor 50, um einen Faktor 100 oder auch um einen noch größeren Faktor größer sein als das Schreibfeld, beispielsweise um einen Faktor 1.000 oder auch 10.000. Die gesamte Substrat-Oberfläche hat eine typische Größe von 20 x 20 cm². Dieser Wert gilt für ein rechteckiges Substrat. Ein typisches rundes Substrat hat eine Fläche, die etwa 75 % der Fläche des rechteckigen Substrats entspricht. Der Schreibfokus hat eine typische Fläche von etwa 1 $\mu$m².

Es lässt sich durch Nutzung der Relativkoordinaten ein hoher Durchsatz bei der Strukturerzeugung gewährleisten. Es können Mikro- und/oder Nanostrukturen hergestellt werden. Bei der lithografischen Strukturerzeugung mit dem optischen System kann eine maskenlose oder eine maskenbasierende Lithografie zum Einsatz kommen. Die Vorschauoptik kann das Vorschaufeld mit einer Vergrößerung im Bereich zwischen 5 und 100, beispielsweise im Bereich zwischen 30 und 40, abbilden.

Zur Erfassung des Vorschaufeldes kann das optische System eine Digitalkamera aufweisen, die als CCD-Kamera ausgebildet sein kann.

Zur Strukturerzeugung kann die Ein-Photonen-Lithografie oder die Mehr-Photonen-Lithografie zum Einsatz kommen.

Eine Prozesskamera nach Anspruch 2 kann zur Bestimmung der Relativkoordinaten der Lage des Schreibfeldes relativ zur Lage des Vorschaufeldes zum Einsatz kommen. Die Prozesskamera kann einen Chip zur ortsauflösenden Erfassung des Schreibfeldes aufweisen. Hierbei kann es sich um einen CCD-Chip oder auch um eine CMOS-Kamera handeln. Das Schreibfeld kann durch eine Schreibfeldbeleuchtung ausgeleuchtet werden, die vom Schreiblichtbündel unabhängig ist. Das Schreibfeld kann durch eine Weitfeldbeleuchtung ausgeleuchtet werden. Eine Lichtquelle für die Schreibfeldbeleuchtung kann als LED ausgeführt sein. Die Erfassung sowohl unabhängigen Lichtes zur Schreibfeldbleuchtung als auch des Schreiblichts über die Prozesskamera ist vorteilhaft, da hierüber eine Beobachtung eines Schreibprozesses erfolgen kann und/oder Rückschlüsse auf eine erfolgte Strukturbildung, insbesondere auf eine erfolgte Polymerisation, gezogen werden können. Das Schreiblicht und/oder unabhängiges Licht zur Schreibfeldbeleuchtung kann in die Prozesskamera über einen Strahlteiler, insbesondere über einen teildurchlässigen Spiegel, eingekoppelt werden.

Mithilfe einer Verlagerbarkeit nach Anspruch 3 kann eine Anpassung von Fokalebenen der Projektionsoptik einerseits relativ zur Vorschauoptik andererseits ermöglicht werden. Die Verlagerung kann mithilfe eines entsprechenden Verlagerungsantriebs erfolgen. Die Vorschauoptik und/oder die Projektionsoptik können in der Richtung senkrecht zur Substratebene verlagerbar ausgeführt sein.

Mithilfe einer Autofokuseinrichtung nach Anspruch 4 lässt sich eine optimale Fokalposition der Projektionsoptik und/oder der Vorschauoptik bestimmen. Die Autofokuseinrichtung kann eine vom Schreiblicht bzw. vom Vorschaulicht unabhängige Beleuchtung aufweisen.

Bildseitige numerische Aperturen nach den Ansprüchen 5 und 6 haben sich für die Funktion der Projektionsoptik einerseits sowie für die Funktion der Vorschauoptik andererseits als besonders geeignet herausgestellt. Die bildseitige numerische Apertur der Vorschauoptik kann beispielsweise 0.05 betragen.

Bei der Lichtquelle nach Anspruch 7 kann es sich um eine gepulste Lichtquelle handeln. Bei der Schreiblicht-Lichtquelle kann es sich um einen NIR-Laser handeln. Bei der Schreiblicht-Lichtquelle kann es sich um eine Ultrakurzpuls-Laserlichtquelle handeln. Für die Vorschauoptik kann eine zur Schreiblicht-Lichtquelle separate Lichtquelle genutzt werden, die ebenfalls Teil des optischen Systems sein kann. Für den Fall, dass das Schreibfeld einerseits und das Vorschaufeld andererseits nicht überlappen, kommt regelmäßig eine von der Schreiblicht-Lichtquelle unabhängige Beleuchtung für die Vorschauoptik zum Einsatz.

Ein Verfahren zur Bestimmung der Relativkoordinaten nach Anspruch 8 hat sich als besonders effizient herausgestellt. Es kann zunächst das Testobjekt im Vorschaufeld mit der Vorschauoptik und anschließend im Schreibfeld mit der Projektionsoptik aufgenommen werden. Auch eine umgekehrte Reihenfolge der Aufnahmen ist möglich.

Eine Feinpositionierung nach Anspruch 9 erhöht die Genauigkeit bei der Bestimmung der Relativkoordinate. Bei der Korrelationsmaximierung kann eine Drehung und/oder eine Stauchung und/oder eine Verschiebung des Testobjekts erfolgen. Zusätzlich zur Feinpositionierung kann bei einer derartigen Korrelationsmaximierung auch eine Überprüfung eines Zusammenspiels der beiden Optiken überprüft und ggf. korrigiert werden. Beispielsweise können die Lagen von Fokalebenen beider Optiken zueinander überprüft und ggf. korrigiert werden. Auch ein vorgegebenes Abbildungsmaßstab-Verhältnis der beiden Optiken kann überwacht werden.

Eine Bildstapel-Aufnahme nach Anspruch 10 erhöht eine Genauigkeit einer Bestimmung der Relativkoordinaten auch längs der Koordinate senkrecht zur Substratebene. Dies verbessert eine Fokuspositionierung bei der lithografischen Strukturerzeugung.

Mit einer mehrfachen Roh-Verlagerung nach Anspruch 11 kann eine Bestimmung der Relativkoordinaten im Rahmen eines iterativen Prozesses erfolgen. Dies erhöht die Genauigkeit der Koordinatenbestimmung.

Ein Verfahren zur lithografischen Strukturerzeugung nach Anspruch 12 nutzt die Vorteile der Relativkoordinatenbestimmung mithilfe des erläuterten optischen Systems.

Ein Ausrichten der Schreib-Zielposition im Vorschaufeld nach Anspruch 13 ermöglicht eine optimierte Nutzung von Positionierungskomponenten beim Schreiben der vorgegebenen Struktur in das Schreibfeld.

Ein Ausführungsbeispiel der Erfindung wird nachfolgend anhand der Zeichnung näher erläutert. In dieser zeigen:

Fig.1 in einer schematischen Seitenansicht Hauptkomponenten eines optischen Systems zur lithografischen Strukturerzeugung; und

Fig.2 ebenfalls schematisch in einer Aufsicht ein Vorschaufeld einer Vorschauoptik des optischen Systems und ein hiervon beabstandetes Schreibfeld, in dem ein Schreibfokus einer Projektionsoptik des optischen Systems angeordnet ist.

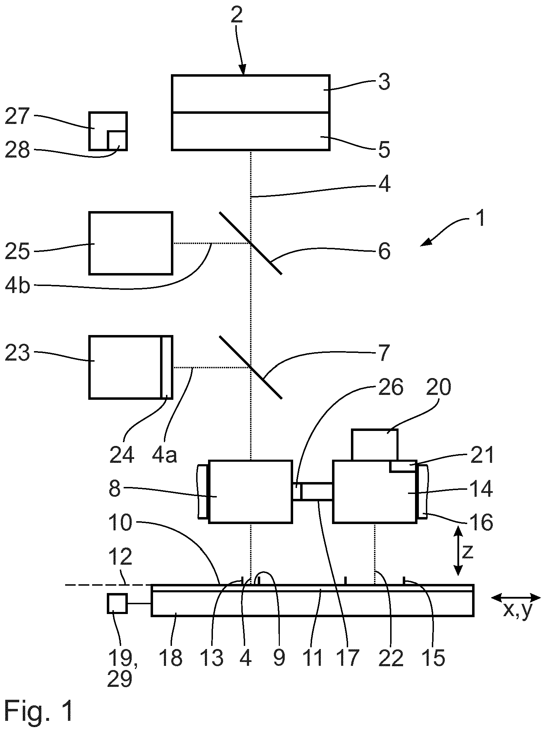

Ein optisches System 1, dessen Hauptkomponenten in der Fig. 1 dargestellt sind, dient zur lithografischen Strukturerzeugung. Ein Strukturerzeugungsverfahren, welches mit dem optischen System 1 durchgeführt werden kann, ist stärker im Detail erläutert in der US 2013/0 221 550 A1. Details eines Erzeugnisses, welches als Ergebnis der Strukturerzeugung resultiert, sind beschrieben in der US 2013/0 223 788 A1.

Teil des optischen Systems 1 ist ein Lithografiesystem 2 mit einer Lichtquelle 3 zur Erzeugung eines Bündels von Schreiblicht 4. Ein Strahlengang des Schreiblichts 4 ist in der Fig. 1 äußerst schematisch gepunktet dargestellt. Bei der Lichtquelle 3 kann es sich um einen gepulsten NIR (Nahes Infrarot)-Laser mit einer Wellenlänge von 780 nm handeln, für den Details ebenfalls in der US 2003/0 221 550 A1 angegeben sind.

Teil des Lithografiesystems 2 ist eine Ablenkeinrichtung 5 für das Schreiblichtbündel. Die Ablenkeinrichtung 5 kann einen oder mehrere verkippbare Scan-Spiegel zur Umlenkung des Schreiblichtbündels aufweisen. Die Ablenkeinrichtung 5 kann mindestens eine optische Komponente beinhalten, die als mikroelektromechanische System (micro electro mechanical system, MEMS)-Komponente ausgeführt ist.

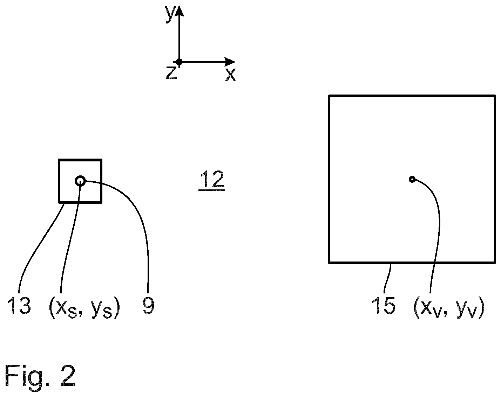

Das Bündel des Schreiblichts 4 passiert in seinem Verlauf nach der Lichtquelle 3 zwei Auskoppelspiegel 6 und 7, die nacheinander im Strahlengang des Schreiblichts 4 angeordnet sind. Im weiteren Verlauf durchtritt das Schreiblicht 4 eine Projektionsoptik 8 in Form eines Mikroskopobjektivs oder in Form eines Lithografieobjektivs. Die Projektionsoptik 8 dient zur Führung des strukturerzeugenden Schreiblichtbündels in einen Schreibfokus 9 (vgl. Fig. 2) im Bereich einer Substrat-Oberfläche 10 eines Substrats 11 in einer Substratebene 12. Eine Fläche, innerhalb der durch den Schreibfokus 9 eine zur Strukturerzeugung genutzte Polymerisation von Substratmaterial herbeigeführt werden kann, kann eine laterale Ausdehnung im Bereich zwischen 1 und 100 $\mu m^2$, beispielsweise zwischen 2 und 10 $\mu m^2$, haben. Der Schreibfokus 9 kann angenähert rund sein, kann aber auch ein x-/y-Aspektverhältnis aufweisen, welches deutlich von 1 abweicht und kann beispielsweise eine laterale Ausdehnung im Bereich von 1 $\mu m$ x 10 $\mu m$ aufweisen.

Eine Struktur wird durch Verlagern des Schreibfokus 9 relativ zum Substratmaterial hergestellt. Die erzeugte Struktur ergibt sich als Summe einer Mehrzahl oder einer Vielzahl polymerisierter Punktbereiche bzw. polymerisierter Linien. Eine typische derartige Struktur kann beispielsweise eine laterale Ausdehnung im Bereich von 5 $\mu m$ x 200 $\mu m$ aufweisen. Bei dem Punktbereich, in dem die Polymerisation stattfindet, handelt es sich ein Volumen-Pixel, also um ein Voxel. Die Projektionsoptik 8 hat eine bildseitige numerische Apertur, die größer ist als 0,5 und die beim Ausführungsbeispiel größer ist als 1,0 und beispielsweise im Bereich zwischen 1,2 und 1,4 liegt.

Die Ablenkeinrichtung 5 dient zur Ablenkung des Schreibfokus 9 des Schreiblichtbündels innerhalb eines Schreibfeldes 13 in der Substratebene 12 im Bereich der Substrat-Oberfläche 10. Innerhalb des gesamten Schreibfeldes 13 kann eine Strukturerzeugung mit Hilfe des Schreibfokus 9 erfolgen. Hierzu kann der Schreibfokus 9 im Schreibfeld 13 bewegt, insbesondere gescannt, werden. Eine erzeugte Struktur kann also deutlich größer sein als die Ausdehnung des Schreibfokus 9.

Die Strukturerzeugung im Schreibfokus 9 kann über einen Ein-Photonen-Prozess oder auch über einen Mehr-Photonen-Prozess geschehen.

Zum optischen System 1 gehört weiterhin eine Vorschauoptik 14 zur Abbildung eines Vorschaufeldes 15 (vgl. wiederum Fig. 2) in der Substratebene 12 im Bereich der Substrat-Oberfläche 10. Das Vorschaufeld 15 hat eine Fläche, die um mindestens einen Faktor 10 größer ist als eine Fläche des Schreibfeldes 13. Das Vorschaufeld 15 kann um mindestens einen Faktor 100 größer sein als die Fläche des Schreibfeldes 13.

Die Felder 13, 15 sind in der Fig. 1 nicht maßstabsgetreu wiedergegeben.

Zur Verdeutlichung von Lagebeziehungen zwischen den Strukturelementen des optischen Systems 1 wird nachfolgend ein kartesisches xyz-Koordinatensystem verwendet. In der Seitenansicht nach Fig.1 steht die xy-Ebene senkrecht auf der Zeichenebene und fällt mit der Substratebene 12 zusammen. Die z-Richtung steht hierauf senkrecht und verläuft in der Fig. 1 nach oben. Eine Ausdehnung der Felder 13, 15 sowie eine Position des Schreibfokus 9 lassen sich also durch x,y-Koordinaten spezifizieren.

Das Schreibfeld 13 hat eine xy-Ausdehnung mit einer typischen Kantenlänge im Bereich zwischen 100 $\mu m$ und 1 mm, beispielsweise eine Erstreckung von 400 $\mu m$ x 400 $\mu m$. Ein Fokusdurchmesser des Schreibfokus 9 in einer Fokalebene des Schreiblichtbündels liegt in einem Bereich zwischen 0,25 $\mu m$ und 50 $\mu m$. Ein typischer Fokusdurchmesser des Schreibfokus 9 liegt bei 1 $\mu m$. Das Schreibfeld 13 ist also typischerweise längs jeder der beiden Koordinaten x und y um mehr als einen Faktor 100 größer als der Durchmesser des Schreibfokus 9.

Das Vorschaufeld 15 hat eine Erstreckung mit einer typischen Kantenlänge zwischen 1 mm und 50 mm, beispielsweise eine typische xy-Ausdehnung von 10 mm x 10 mm. Das Vorschaufeld 15 kann noch größer sein und eine typische xy-Ausdehnung beispielsweise von 50 mm x 50 mm haben. Das Vorschaufeld 15 ist kleiner als die gesamte Substrat-Oberfläche 10, die eine Fläche von beispielsweise 20 x 20 $cm^2$ haben kann. Das Substrat 11 kann rechteckig oder rund sein. Die Fläche des runden Substrats ist typischerweise einen Faktor 0,75 kleiner als diejenige des reckteckigen Substrats.

Die Vorschauoptik 14 vergrößert das Vorschaufeld 15 mit einer Vergrößerung im Bereich zwischen 5 und 100, typischerweise zwischen 30 und 40. Ein Arbeitsabstand zwischen einer substratnächsten Komponente der Vorschauoptik 14 und dem Substrat 10 liegt im Bereich zwischen 1 mm und 30 mm und beträgt typischerweise 10 mm.

Die Vorschauoptik 14 hat eine bildseitige numerische Apertur, die kleiner ist als 0,1 und die beispielsweise 0,05 betragen kann.

Die Projektionsoptik 8 und die Vorschauoptik 14 sind von einem gemeinsamen Rahmen 16 getragen, der in der Fig. 1 schematisch und gebrochen angedeutet ist. Die Projektionsoptik 8 oder die Vorschauoptik 14 sind über einen Rahmenträger 17 in Bezug auf die Koordinaten x und y starr miteinander verbunden.

Das Substrat 11 wird von einem Substrathalter 18 getragen. Dieser ist in der xy-Ebene in den beiden Translationsfreiheitsgraden x und y verlagerbar. Hierzu ist der Substrathalter 18 mit einem xy-Verlagerungsantrieb 19 verbunden. Der Substrathalter 18 mit dem xy-Verlagerungsantrieb 19 kann als xy-Tisch mit einer Positionier-Wiederholgenauigkeit besser als 5 $\mu m$ ausgeführt sein.

Zur Detektion des Vorschaufeldes 15 weist die Vorschauoptik 14 eine CCD-Kamera 20 auf. Alternativ oder zusätzlich kann die Vorschauoptik 14 einen Tubus zur Sichtkontrolle über eine Bedienperson aufweisen. Eine Ausleuchtung des Vorschaufeldes 15 erfolgt über eine in die Vorschauoptik 14 integrierte Vorschau-Lichtquelle 21, die von der Schreiblicht-Lichtquelle 3 unabhängig ist. Die Vorschau-Lichtquelle 21 erzeugt Vorschaulicht 22 zur Ausleuchtung des Vorschaufeldes 15. Der Strahlengang des Vorschaulichtes 22 ist in der Fig. 1 ebenfalls äußerst schematisch gepunktet angedeutet. Bei der Vorschau-Lichtquelle 21 kann es sich um eine Lichtquelle im sichtbaren Wellenlängenbereich handeln. Alternativ ist es prinzipiell möglich, die Schreiblicht-Lichtquelle 3 auch zur Erzeugung von Vorschaulicht zur Ausleuchtung des Vorschaufeldes 15 heranzuziehen.

Die Vorschau-Lichtquelle kann eine Weitfeld-Beleuchtung und/oder eine strukturierte Beleuchtung herbeiführen. Hierbei kann ein Speckle-Muster oder auch eine Streifenprojektion genutzt werden.

Das optische System 1 umfasst weiterhin eine Prozesskamera 23 zur Erfassung des Schreibfeldes 13. Dies geschieht unter Nutzung einer separaten Beleuchtung des Schreibfeldes, was in der Zeichnung nicht näher dargestellt ist. Alternativ oder zusätzlich kann zur Erfassung jedenfalls eines Teils des Schreibfeldes 13 der Strahlengang des Schreiblichtbündels in der Projektionsoptik 8 genutzt werden. Vom Schreibfeld 13 in die Projektionsoptik 8 retroreflektiertes Licht, z. B. das Schreiblicht 4, wird vom teiltransparenten Auskoppelspiegel 7 in die Prozesskamera 23 ausgekoppelt. Die Prozesskamera 23 weist einen CCD-Chip 24 zur Erfassung des über den Auskoppelspiegel 7 ausgekoppelten Lichts 4a auf. Sofern zur Erfassung des Schreibfeldes 13 eine von der Schreiblicht-Lichtquelle unabhängige Beleuchtung zum Einsatz kommt, kann trotzdem zusätzlich auch das Schreiblicht 4 über die Prozesskamera 23 erfasst werden.

Weiterhin umfasst das optische System 1 eine Autofokuseinrichtung 25 zur Bestimmung einer Fokusebene der Projektionsoptik 8 und/oder der Vorschauoptik 14. Die Autofokuseinrichtung 25 erfasst dabei ein weiteres, über den teiltransparenten Auskoppelspiegel 6 ausgekoppeltes Lichtbündel 4b. Die Autofokuseinrichtung 25 kann über eine eigene Beleuchtung verfügen, was in der Zeichnung nicht näher dargestellt ist.

Die Projektionsoptik 8 ist relativ zur Vorschauoptik 14 in z-Richtung, also senkrecht zur Substratebene 12, verlagerbar. Hierzu ist die Projektionsoptik 8 mit einem z-Verlagerungsantrieb 26 ausgerüstet. Der z-Verlagerungsantrieb 26 ist in der Fig. 1 schematisch angedeutet und ist zwischen dem Rahmenträger 17 und der Projektionsoptik 8 angeordnet. Bei dieser z-Verlagerung der Projektionsoptik 8 relativ zur Vorschauoptik 14 ist eine Relativbewegung der beiden Optiken 8, 14 zueinander geführt über eine z-Führung. Diese z-Führung ist Teil des Rahmenträgers 17.

Mithilfe des z-Verlagerungsantriebs 26 kann eine Anpassung der Fokalebenen der Projektionsoptik 8 und der Vorschauoptik 14 erfolgen.

Das optische System 1 hat weiterhin eine Steuereinheit 27. Die Steuereinheit 27 hat einen Speicher 28, in dem Relativkoordinaten ($RK_x$, $RK_y$) der Lage des Schreibfeldes 13 relativ zur Lage des Vorschaufeldes 15 abgelegt sind.

Mithilfe des optischen Systems 1 können lithografisch Mikro- und/oder Nanostrukturen erzeugt werden. Dies kann maskenlos, also ohne Abbildung einer Objektstruktur auf die Substrat-Oberfläche 10, alternativ aber auch maskenbasierend erfolgen.

Zur Bestimmung der Relativkoordinaten $RK_x$, $RK_y$ der Lage des Schreibfeldes 13 relativ zur Lage des Vorschaufeldes 15 wird folgendermaßen vorgegangen: Zunächst wird ein Testobjekt, beispielsweise eine Rechteckstruktur mit vorgegebenem x/y-Aspektverhältnis, mit der Vorschauoptik 14 aufgenommen. Die Lage des Testobjekts im Vorschaufeld 15 wird mittels der CCD-Kamera 20 erfasst. Anschließend wird das Testobjekt in Vorschaufeld 15 mithilfe des xy-Verlagerungsantriebs 19 positioniert, so dass das Testobjekt im Vorschaufeld 15 eine definierte Lage hat. Diese Lage kann beispielsweise so gewählt werden, dass eine Markierung auf dem Testobjekt auf den zentralen Koordinaten $x_v$, $y_v$ (vgl. Fig. 2) des Vorschaufeldes 15 zu liegen kommt.

Gleichzeitig kann durch geregelte Betätigung des z-Verlagerungsantriebs 26 sichergestellt werden, dass das Testobjekt optimal in einer bildseitigen Fokalebene der Vorschauoptik 14 liegt.

Anschließend wird das Testobjekt mithilfe des xy-Verlagerungsantriebs 19 auf dem Substrathalter 18 zwischen dem Vorschaufeld 15 und dem Schreibfeld 13 roh-verlagert. Bei dieser Roh-Verlagerung werden Roh-Relativkoordinaten $RK_{x,roh}$; $RK_{y,roh}$ dokumentiert und im Speicher 28 abgelegt. Ziel der Roh-Verlagerung ist es, das Testobjekt in das Schreibfeld 13 zu verlagern.

Anschließend wird das Testobjekt mit der Projektionsoptik 8 und der Prozesskamera 23 aufgenommen. Anschließend wird das Testobjekt im Schreibfeld 13 fein positioniert, bis das Testobjekt im Schreibfeld 13 eine definierte Lage hat. Diese definierte Lage kann beispielsweise so sein, dass die Markierung des Testobjekts nach erfolgter Feinpositionierung im Schreibfeld 13 mit einem Zentrum $x_s$, $y_s$ (vgl. Fig. 2) des Schreibfeldes 13 übereinstimmt. Auch die Änderungen der Roh-Relativkoordinaten des Testobjekts bei der Feinpositionierung werden dokumentiert und im Speicher 28 abgelegt. Aus den Roh-Relativkoordinaten und den dokumentierten Änderungen bei der Feinpositionierung können dann die gewünschten Relativkoordinaten der Lage des Schreibfeldes 13 relativ zur Lage des Vorschaufeldes 15 dokumentiert und im Speicher 28 abgelegt werden. Beim Beispiel nach Fig. 2 ergibt sich folgender Zusammenhang zwischen den Relativkoordinaten $RK_x$, $RK_y$ und den Koordinaten $x_v$, $y_v$ und $x_s$, $y_s$ der Felder 15 und 13:

$$RK_x, RK_y = (x_v - x_s), (y_v - y_s)$$

Die erzeugten Relativkoordinaten $RK_x$, $RK_y$ werden dann im Speicher 28 der Steuereinheit 27 abgelegt und stehen für einen nachfolgenden Abruf beim Verlagern eines Substrats, auf dem lithografisch eine Struktur erzeugt werden soll, in eine Schreib-Zielposition zur Verfügung.

Nach erfolgter Bestimmung der Relativkoordinaten $RK_x$, $RK_y$ ist die Vorschauoptik 14 relativ zur Positionsoptik 8 kalibriert. Eine Verlagerung des Substrathalters 18 um die Koordinaten ($RK_x$, $RK_y$) überführt ein vom Substrathalter getragenes Objekt vom Zentrum des Vorschaufeldes 15 in das Zentrum des Schreibfeldes 13.

Durch Kenntnis der Ausdehnung des Vorschaufeldes 15 kann auch eine vom Benutzer ausgewählte Position im Vorschaufeld 15 direkt auf ein Zentrum im Schreibfeld 13 überführt werden. Dies geschieht, indem die Steuereinheit 27 zunächst diese ausgewählte Position im Vorschaufeld 15 zentriert, was durch entsprechende Positionierung über den xy-Verlagerungsantrieb 19 und Dokumentierung entsprechender Relativkoordinaten erfolgt. Anschließend wird die vorstehend beschriebene Überführungs-Verlagerung durchgeführt. Die Zentrierung und die Überführungs-Verlagerung können auch innerhalb eines Schrittes kombiniert werden.

Das vorstehend beschriebene Bestimmungsverfahren kann alternativ auch ausgehend von einer Aufnahme des Testobjekts im Schreibfeld 13 erfolgen, wobei dann das Testobjekt zunächst im Schreibfeld 13 positioniert wird und anschließend eine Roh-Verlagerung des Testobjekts vom Schreibfeld 13 in das Vorschaufeld 15 mit entsprechender Feinpositionierung innerhalb des Vorschaufeldes 15 erfolgt. Die Dokumentation zunächst der Roh-Relativkoordinaten und die Erzeugung hieraus und dem Ergebnis der Feinpositionierung der gewünschten Relativkoordinaten erfolgt dann analog zu dem, was vorstehend im Zusammenhang mit dem Bestimmungsverfahren, ausgehend vom Testobjekt im Vorschaufeld 15, bereits erläutert wurde.

Je nach der Reihenfolge einer Positionierung des Testobjekts handelt es sich beim Ausgangsfeld also entweder um das Vorschaufeld 15 oder um das Schreibfeld 13 und beim Zielfeld entweder um das Schreifeld 13 oder um das Vorschaufeld 15.

Bei der Feinpositionierung erfolgt eine Korrelationsmaximierung der Lagen des Testobjekts im Ausgangsfeld einerseits und im Zielfeld andererseits. Diese Korrelationsmaximierung erfolgt durch Drehung des Testobjektes und/oder durch Stauchung des Testobjektes und/oder durch Verschiebung des Testobjektes.

Die Drehung erfolgt um eine zur z-Achse parallele Achse, was durch einen zusätzlichen Schwenkmotor 29 des Substrathalters 18 erfolgen kann. Alternativ kann eine Drehung auch durch eine Bilddrehung der jeweiligen Erfassungsoptik bei der Darstellung für den Benutzer geschehen. Zur Erfassung einer solchen Drehung sind mehrere Markierungen an verschiedenen x,y-Positionen des Testobjekts aufgebracht. Nach dem Roh-Verlagern bzw. bei Feinpositionierung kann durch Drehung eine Übereinstimmung dieser Testmarkierungen mit Zielmarkierungen maximiert werden.

Bei der Stauchung wird über den z-Verlagerungsantrieb 26 ein Abbildungsmaßstab-Verhältnis zwischen der Produktionsoptik 8 und der Vorschauoptik 14 variiert, bis ein vorgegebenes Verhältnis mit einem Abstandsverhältnis von Testmarkierungen auf dem Testobjekt bei der Aufnahme einerseits über die Vorschauoptik 14 und andererseits über die Projektionsoptik 8 übereinstimmt.

Die Korrelationsmaximierung durch Verschiebung, also durch Translation in den Freiheitsgraden x und y, wurde vorstehend im Zusammenhang mit der Fig. 2 bereits erläutert.

Bei der Testobjekt-Aufnahme kann ein Bildstapel durch Aufnahme verschiedener Bilder des Testobjekts mit der jeweiligen Aufnahme-Optik, also mit der Projektionsoptik 8 oder der Vorschauoptik 14, in verschiedenen z-Verlagerungspositionen dieser Aufnahme-Optik relativ zum Testobjekt in der z-Verlagerungsrichtung senkrecht zur xy-Substratebene 12 erzeugt werden.

Zusätzlich zu den Relativkoordinaten längs der x- und längs der y-Koordinate kann auch eine Relativkoordinate in z-Richtung abgelegt werden, sofern zwischen Fokalebenen der Projektionsoptik 8 einerseits und der Vorschauoptik 14 andererseits eine z-Ablage der Fokalebenen vorliegt.

Bei der Bestimmung der Relativkoordinaten kann mehrfach ein Roh-Verlagern des Testobjekts zwischen den Feldern 13, 15 erfolgen. Das Bestimmen der Relativkoordinaten kann dann im Rahmen eines iterativen Prozesses erfolgen.

Zur lithografischen Strukturerzeugung mit dem optischen System 1 werden zunächst, wie vorstehend erläutert, die Relativkoordinaten der Lage des Schreibfeldes 13 relativ zur Lage des Vorschaufeldes 15 bestimmt. Anschließend wird das Substrat 11 auf dem Substrathalter 18 bereitgestellt. Es kann dann ein für die Strukturierung vorgesehener Teilbereich auf dem gesamten Substrat 11 unter das Vorschaufeld 15 mit Hilfe des xy-Verlagerungsantriebs 19 gefahren werden. Es wird dann eine Schreib-Zielposition auf dem Substrat 11 im Vorschaufeld 15 identifiziert und durch den Benutzer ausgewählt. Diese Schreib-Zielposition kann dann im Vorschaufeld 15 ausgerichtet werden. Anschließend wird die Schreib-Zielposition vom Vorschaufeld 15 in das Schreibfeld 13 unter Nutzung der bestimmten Relativkoordinaten $RK_x$, $RK_y$ verlagert. Sodann wird eine vorgegebene Struktur in das Schreibfeld 13 mit dem Schreiblichtbündel geschrieben, wobei der Schreibfokus 9 entsprechend der Form der vorgegebenen Struktur mithilfe der Ablenkeinrichtung 5 im Schreibfeld 13 verlagert wird.

Als Substrat 11 kann ein Wafer mit einem Durchmesser beispielsweise von etwa 15 cm (6 Zoll) oder von etwa 20 cm (8 Zoll) zum Einsatz kommen. Auch ein Wafer mit einem noch größeren Durchmesser kann zum Einsatz kommen.

**Patentansprüche**

1. Optisches System (1) zur lithografischen Strukturerzeugung

     - mit einer Projektionsoptik (8) zur Führung eines strukturerzeugenden Schreiblichtbündels in einen Schreibfokus (9) im Bereich einer Substrat-Oberfläche (10) in einer Substratebene (12),
     - mit einer Ablenkeinrichtung (5) zur Ablenkung des Schreibfokus (9) des Schreiblichtbündels innerhalb eines Schreibfeldes (13) im Bereich der Substrat-Oberfläche (10),
- mit einer Vorschauoptik (14) zur Abbildung eines Vorschaufeldes (15) im Bereich der Substrat-Oberfläche (10), wobei das Vorschaufeld (15) eine Fläche aufweist, die um mindestens einen Faktor 10 größer ist als eine Fläche des Schreibfeldes (13),
- wobei die Projektionsoptik (8) und die Vorschauoptik (14) von einem gemeinsamen Rahmen (16) getragen werden,
- mit einem Substrathalter (18), der in einer Ebene (xy) parallel zur Substrat-Oberfläche (10) in zwei Translationsfreiheitsgraden (x, y) verlagerbar ist,
- mit einer Steuereinheit (27) mit einem Speicher (28), in dem Relativkoordinaten $(RK_x, RK_y)$ einer Lage des Schreibfeldes (13) relativ zur Lage des Vorschaufeldes (15) abgelegt sind.

2. Optisches System nach Anspruch 1, **gekennzeichnet durch** eine Prozesskamera (23) zur Erfassung des Schreibfeldes (13) unter Nutzung des Strahlengangs des Schreiblichtbündels in der Projektionsoptik (8).

3. Optisches System nach Anspruch 1 oder 2, **dadurch gekennzeichnet, dass** die Projektionsoptik (8) relativ zur Vorschauoptik (14) in einer Richtung (z) senkrecht zur Substratebene (12) verlagerbar ist.

4. Optisches System nach einem der Ansprüche 1 bis 3, **gekennzeichnet durch** eine Autofokuseinrichtung (25) zur Bestimmung einer Fokusebene der Projektionsoptik (8) und/oder der Vorschauoptik (14).

5. Optisches System nach einem der Ansprüche 1 bis 4, **dadurch gekennzeichnet, dass** die Projektionsoptik (8) eine bildseitige numerische Apertur aufweist, die größer ist als 1,0.

6. Optisches System nach einem der Ansprüche 1 bis 5, **dadurch gekennzeichnet, dass** die Vorschauoptik (14) eine bildseitige numerische Apertur aufweist, die kleiner ist als 0,1.

7. Optisches System nach einem der Ansprüche 1 bis 6, **gekennzeichnet durch** eine Lichtquelle (3) zur Erzeugung von Schreiblicht (4).

8. Verfahren zur Bestimmung von Relativkoordinaten $(RK_x, RK_y)$ einer Lage eines Schreibfeldes (13) relativ zu einer Lage eines Vorschaufeldes (15) in einem optischen System (1) nach einem der Ansprüche 1 bis 7 mit folgenden Schritten:

- Aufnehmen eines Testobjektes mit einer der beiden Optiken (8, 14) aus der Optikgruppe:

Vorschauoptik (14) und Projektionsoptik (8) in einem Ausgangsfeld (13, 15), nämlich in einem der beiden Felder aus der Feldgruppe: Vorschaufeld (15) und Schreibfeld (13),
- Positionieren des Testobjekts im Ausgangsfeld (13, 15), so dass das Testobjekt im Ausgangsfeld (13, 15) eine definierte Lage hat,
- Roh-Verlagern des Testobjekts mit dem Substrathalter (18) zwischen dem Ausgangsfeld (13, 15) und einem Zielfeld (15, 13), nämlich dem anderen der beiden Felder aus der Feldgruppe,
- Dokumentieren von Roh-Relativkoordinaten $(RK_{x,\,roh}; RK_{y,\,roh})$ dieser Roh-Verlagerung,
- Aufnehmen des Testobjektes mit der anderen der beiden Optiken (14, 8) aus der Optikgruppe,
- Feinpositionieren des Testobjekts im Zielfeld (15, 13), so dass das Testobjekt im Zielfeld (15, 13) eine definierte Lage hat,
- Dokumentieren von Änderungen der Roh-Relativkoordinaten $(RK_{x,roh}; RK_{y,roh})$ bei der Feinpositionierung und Erzeugen der Relativkoordinaten $(RK_x, RK_y)$ aus den Roh-Relativkoordinaten $(RK_{x,roh}; RK_{y,roh})$ und dem Ergebnis der Dokumentation.

9. Verfahren nach Anspruch 8, **dadurch gekennzeichnet, dass** bei der Feinpositionierung eine Korrelationsmaximierung der Lagen des Testobjekts im Ausgangsfeld (13, 15) einerseits und im Zielfeld (15, 13) andererseits erfolgt.

10. Verfahren nach Anspruch 8 oder 9, **dadurch gekennzeichnet, dass** bei der Testobjekt-Aufnahme ein Bildstapel durch Aufnahme verschiedener Bilder des Testobjekts mit der Aufnahme-Optik (8, 14) in verschiedenen Verlagerungspositionen der Aufnahme-Optik (14, 8) relativ zum Testobjekt in einer Verlagerungsrichtung (z) senkrecht zur Substratebene (12) erzeugt wird.

11. Verfahren nach einem der Ansprüche 8 bis 10, **dadurch gekennzeichnet, dass** bei der Bestimmung mehrfach ein Roh-Verlagern des Testobjekts zwischen den Feldern (13, 15) der Feldgruppe erfolgt.

12. Verfahren zur lithografischen Strukturerzeugung mit dem optischen System (1) nach einem der Ansprüche 1 bis 7 mit folgenden Schritten:

- Bestimmen der Relativkoordinaten $(RK_x; RK_y)$ der Lage des Schreibfeldes (13) relativ zur Lage des Vorschaufeldes (15) mit dem Verfahren nach einem der Ansprüche 8 bis 11,
- Bereitstellen des Substrats (11) auf dem Substrathalter (18),
- Bestimmen einer Schreib-Zielposition auf dem Substrat (11) im Vorschaufeld (15),

- Verlagern der Schreib-Zielposition vom Vorschaufeld (15) in das Schreibfeld (13) unter Nutzung der bestimmten Relativkoordinaten ($RK_x$, $RK_y$),
- Schreiben einer vorgegebenen Struktur in das Schreibfeld (13) mit dem Schreiblichtbündel.

13. Verfahren nach Anspruch 12, **dadurch gekennzeichnet, dass** vor dem Verlagern der Schreib-Zielposition vom Vorschaufeld (15) in das Schreibfeld (13) ein Ausrichten der Schreib-Zielposition im Vorschaufeld (15) erfolgt.

**Claims**

1. Optical system (1) for producing lithographic structures,

   - comprising a projection optical unit (8) for guiding a structure-producing writing light beam into a writing focus (9) in the region of a substrate surface (10) in a substrate plane (12),
   - comprising a deflection device (5) for deflecting the writing focus (9) of the writing light beam within a writing field (13) in the region of the substrate surface (10),
   - comprising a preview optical unit (14) for imaging a preview field (15) in the region of the substrate surface (10), wherein the preview field (15) has an area which is greater than an area of the writing field (13) by at least a factor of 10,
   - wherein the projection optical unit (8) and the preview optical unit (14) are carried by a common frame (16),
   - comprising a substrate holder (18), which is displaceable in a plane (xy) parallel to the substrate surface (10) with two degrees of translational freedom (x,y),
   - comprising a control unit (27) comprising a memory (28), in which relative coordinates ($RK_x$, $RK_y$) of a position of the writing field (13) relative to the position of the preview field (15) are stored.

2. Optical system according to Claim 1, **characterized by** a process camera (23) for capturing the writing field (13) using the beam path of the writing light beam in the projection optical unit (8).

3. Optical system according to Claim 1 or 2, **characterized in that** the projection optical unit (8) is displaceable relative to the preview optical unit (14) in a direction (z) perpendicular to the substrate plane (12).

4. Optical system according to any one of Claims 1 to 3, **characterized by** an autofocusing device (25) for determining a focal plane of the projection optical unit (8) and/or of the preview optical unit (14).

5. Optical system according to any one of Claims 1 to 4, **characterized in that** the projection optical unit (8) has an image-side numerical aperture which is greater than 1.0.

6. Optical system according to any one of Claims 1 to 5, **characterized in that** the preview optical unit (14) has an image-side numerical aperture which is less than 0.1.

7. Optical system according to any one of Claims 1 to 6, **characterized by** a light source (3) for producing writing light (4).

8. Method for determining relative coordinates ($RK_x$, $RK_y$) of a position of a writing field (13) relative to a position of a preview field (15) in an optical system (1) according to any one of claims 1 to 7, said method comprising the following steps:

   - recording a test object using one of the two optical units (8, 14) from the optical group: preview optical unit (14) and projection optical unit (8) in an initial field (13, 15), namely in one of the two fields from the field group: preview field (15) and writing field (13),
   - positioning the test object in the initial field (13, 15) such that the test object has a defined position in the initial field (13, 15),
   - carrying out, by way of the substrate holder (18), a coarse displacement of the test object between the initial field (13, 15) and a target field (15, 13), namely the other of the two fields from the field group,
   - registering coarse relative coordinates ($RK_{x, coarse}$; $RK_{y, coarse}$) of this coarse displacement,
   - recording the test object using the other of the two optical units (14, 8) from the optical group,
   - finely positioning the test object in the target field (15, 13) such that the test object has a defined position in the target field (15, 13),
   - registering changes in the coarse relative coordinates ($RK_{x, coarse}$; $RK_{y, coarse}$) during the fine positioning and producing the relative coordinates ($RK_x$, $RK_y$) from the coarse relative coordinates ($RK_{x, coarse}$; $RK_{y, coarse}$) and the result of the registration.

9. Method according to Claim 8, **characterized in that** a correlation of the position of the test object in the initial field (13, 15) on the one hand and in the target field (15, 13) on the other hand is maximized during the fine positioning.

**10.** Method according to Claim 8 or 9, **characterized in that** an image stack is produced during the test object recording by recording various images of the test object using the recording optical unit (8, 14) in various displacement positions of the recording optical unit (14, 8) relative to the test object in a displacement direction (z) perpendicular to the substrate plane (12).

**11.** Method according to any one of Claims 8 to 10, **characterized in that** a coarse displacement of the test object between the fields (13, 15) of the field group occurs multiple times during the determination.

**12.** Method for producing lithographic structures using the optical system (1) according to any one of Claims 1 to 7, said method comprising the following steps:

- determining the relative coordinates (RK$_x$; RK$_y$) of the position of the writing field (13) relative to the position of the preview field (15) using the method according to any one of Claims 8 to 11,
- providing the substrate (11) on the substrate holder (18),
- determining a writing target position on the substrate (11) in the preview field (15),
- displacing the writing target position from the preview field (15) into the writing field (13) using the determined relative coordinates (RK$_x$, RK$_y$),
- writing a predetermined structure into the writing field (13) using the writing light beam.

**13.** Method according to Claim 12, **characterized in that** the writing target position is aligned in the preview field (15) before the writing target position is displaced from the preview field (15) into the writing field (13).

**Revendications**

**1.** Système optique (1) destiné à la génération de structure lithographique

- comprenant une optique de projection (8) servant à guider un faisceau de lumière d'écriture générateur de structure dans un foyer d'écriture (9) dans la zone d'une surface de substrat (10) dans un plan de substrat (12),
- comprenant un dispositif de déviation (5) destiné à dévier le foyer d'écriture (9) du faisceau de lumière d'écriture à l'intérieur d'un champ d'écriture (13) dans la zone de la surface de substrat (10),
- comprenant une optique de prévisualisation (14) destinée à représenter un champ de prévisualisation (15) dans la zone de la surface de substrat (10), le champ de prévisualisation (15) possédant une surface qui est plus grande d'au moins un facteur 10 qu'une surface du champ d'écriture (13),
- l'optique de projection (8) et l'optique de prévisualisation (14) étant portées par un cadre commun (16),
- comprenant un élément de maintien de substrat (18) qui peut être déplacé dans un plan (xy) parallèlement à la surface de substrat (10) dans deux degrés de liberté de translation (x, y),
- comprenant une unité de commande (27) dotée d'une mémoire (28) dans laquelle sont stockées des coordonnées relatives (RK$_x$, RK$_y$) d'une position du champ d'écriture (13) par rapport à la position du champ de prévisualisation (15).

**2.** Système optique selon la revendication 1, **caractérisé par** une caméra de processus (23) destinée à acquérir le champ d'écriture (13) en utilisant le trajet de rayon du faisceau de lumière d'écriture dans l'optique de projection (8).

**3.** Système optique selon la revendication 1 ou 2, **caractérisé en ce que** l'optique de projection (8) peut être déplacée par rapport à l'optique de prévisualisation (14) dans une direction (z) perpendiculairement au plan de substrat (12).

**4.** Système optique selon l'une des revendications 1 à 3, **caractérisé par** un dispositif de mise au point automatique (25) destiné à déterminer un plan focal de l'optique de projection (8) et/ou de l'optique de prévisualisation (14).

**5.** Système optique selon l'une des revendications 1 à 4, **caractérisé en ce que** l'optique de projection (8) présente une ouverture numérique côté image qui est supérieure à 1,0.

**6.** Système optique selon l'une des revendications 1 à 5, **caractérisé en ce que** l'optique de prévisualisation (14) présente une ouverture numérique côté image qui est inférieure à 0,1.

**7.** Système optique selon l'une des revendications 1 à 6, **caractérisé par** une source de lumière (3) destinée à générer de la lumière d'écriture (4).

**8.** Procédé de détermination des coordonnées relatives (RK$_x$, RK$_y$) d'une position d'un champ d'écriture (13) par rapport à une position d'un champ de prévisualisation (15) dans un système optique (1) selon l'une des revendications 1 à 7, comprenant les étapes suivantes :

- enregistrement d'un objet de test avec l'une des deux optiques (8, 14) du groupe d'optiques : optique de prévisualisation (14) et optique de projection (8) dans un champ d'origine (13, 15), à savoir dans l'un des deux champs du groupe de champs : champ de prévisualisation (15) et champ d'écriture (13),
- positionnement de l'objet de test dans le champ d'origine (13, 15) de telle sorte que l'objet de test ait une position définie dans le champ d'origine (13, 15),
- déplacement grossier de l'objet de test avec l'élément de maintien de substrat (18) entre le champ d'origine (13, 15) et un champ cible (15, 13), à savoir l'autre des deux champs du groupe de champs,
- documentation des coordonnées relatives brutes ($RK_{x,roh}$, $RK_{y,roh}$) de ce déplacement grossier,
- enregistrement de l'objet de test avec l'autre des deux optiques (14, 8) du groupe d'optiques,
- positionnement précis de l'objet de test dans le champ cible (15, 13) de telle sorte que l'objet de test ait une position définie dans le champ cible (15, 13),
- documentation des modifications des coordonnées relatives brutes ($RK_{x,roh}$, $RK_{y,roh}$) lors du positionnement précis et génération des coordonnées relatives ($RK_x$, $RK_y$) à partir des coordonnées relatives brutes ($RK_{x,roh}$, $RK_{y,roh}$) et du résultat de la documentation.

**9.** Procédé selon la revendication 8, **caractérisé en ce que** lors du positionnement précis, une maximisation de la corrélation des positions de l'objet de test dans le champ d'origine (13, 15) d'une part et dans le champ cible (15, 13) d'autre part est effectuée.

**10.** Procédé selon la revendication 8 ou 9, **caractérisé en ce que** lors de l'enregistrement de l'objet de test, une pile d'images est générée en enregistrant différentes images de l'objet de test avec l'optique d'enregistrement (8, 14) dans différentes positions de déplacement de l'optique d'enregistrement (14, 8) par rapport à l'objet de test dans une direction de déplacement (z) perpendiculairement au plan de substrat (12).

**11.** Procédé selon l'une des revendications 8 à 10, **caractérisé en ce que** lors de la détermination, un déplacement grossier de l'objet de test entre les champs (13, 15) du groupe de champs est effectué plusieurs fois.

**12.** Procédé de génération de structure lithographique avec le système optique (1) selon l'une des revendications 1 à 7, comprenant les étapes suivantes :

- détermination des coordonnées relatives ($RK_x$, $RK_y$) de la position du champ d'écriture (13) par rapport à la position du champ de prévisualisation (15) avec le procédé selon l'une des revendications 8 à 11,
- fourniture du substrat (11) sur l'élément de maintien de substrat (18),
- détermination d'une position cible d'écriture sur le substrat (11) dans le champ de prévisualisation (15),
- déplacement de la position cible d'écriture du champ de prévisualisation (15) dans le champ d'écriture (13) en utilisant les coordonnées relatives ($RK_x$, $RK_y$) déterminées,
- écriture d'une structure prédéfinie dans le champ d'écriture (13) avec le faisceau de lumière d'écriture.

**13.** Procédé selon la revendication 12, **caractérisé en ce qu'**un alignement de la position cible d'écriture dans le champ de prévisualisation (15) est effectué avant le déplacement de la position cible d'écriture du champ de prévisualisation (15) dans le champ d'écriture (13).

Fig. 1

y

z          x

12

13   $(x_s, y_s)$   9

15   $(x_v, y_v)$

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014220168
- US 20130221550 A1
- US 20130223788 A1
- DE 10315086 A1
- US 20080112609 A1
- US 20030221550 A1